# EUROPÄISCHE PATENTSCHRIFT

(11) **EP 1 063 590 B1**
(45) Veröffentlichungstag und Bekanntmachung des Hinweises auf die Patenterteilung: **25.06.2003**
(21) Anmeldenummer: 99112195.5
(22) Anmeldetag: 24.06.1999
(51) Int. Cl.: G06F 11/22, G01R 31/3185

(54) **Verfahren zur Konfiguration eines modularen elektronischen Systems und in dem System verwendetes Modul**
Method to configure a modular electronic system, and module used in this system
Procédé de configuration d'un système électronique modulaire, et module utilisé dans le système

(43) Veröffentlichungstag der Anmeldung: 27.12.2000
(73) Patentinhaber: FRAUNHOFER-GESELLSCHAFT ZUR FÖRDERUNG DER ANGEWANDTEN FORSCHUNG E.V., 80636 München (DE)
(72) Erfinder: Kemmerling, Martin Dipl.-Ing., 58300 Wetter (Ruhr) (DE); Hildebrand, Robert Dipl.-Ing., 45279 Essen (DE)
(74) Vertreter: Schoppe, Fritz, Dipl.-Ing.

(56) Entgegenhaltungen:
- EP-A- 0 793 169
- WO-A-89/12274
- GB-A- 2 202 062

## Beschreibung

Die vorliegende Erfindung bezieht sich auf ein Verfahren zur Konfiguration von modularen elektronischen Systemen und insbesondere auf ein solches Verfahren, das zur Selbstkonfiguration eines modularen elektronischen System geeignet ist. Die vorliegende Erfindung bezieht sich ferner auf ein in einem modularen elektronischen System verwendetes Modul.

Elektronische Systeme werden häufig in Form eines Baukastensystems aufgebaut. Ein solches System besteht aus mechanisch gleichartig gestalteten, jedoch mit unterschiedlichen technischen Funktionalitäten ausgestatteten Komponenten, die als Module bezeichnet werden. Diese Module oder Bausteine lassen sich je nach Anwendungszweck und nach individuellen technischen und gestalterischen Aspekten zu einer funktionalen Einheit zusammensetzen. Damit das Zusammenspiel der Einzelkomponenten in der geplanten Anwendung perfekt funktioniert, muß das Gesamtsystem über seine Zusammensetzung und die genaue Lage und Identität seiner Einzelkomponenten bzw. Module detaillierte Kenntnis haben. Zu diesem Zweck ist eine Systemkonfiguration erforderlich.

Zum Durchführen einer solchen Systemkonfiguration ist eine Anzahl von Möglichkeiten bekannt. Eine Variante für eine solche Konfiguration besteht darin, daß die Module einzeln beispielsweise mit Hilfe von Schaltern, Jumpern oder ähnlichen Einstellelementen auf ihre im Gesamtsystem erforderlichen Parameter voreingestellt werden. Ferner ist es bekannt, einen I²C-Bus zur Systemkonfiguration zu verwenden, wobei Adressen verwendet werden, die entweder bausteinspezifisch sind oder in einem begrenzten Adressraum durch externe Signale variiert werden können. Der Nachteil an dieser Vorgehensweise besteht darin, daß die Verwendung mehrere gleichartiger Bausteine limitiert ist. Bei dem sogenannten SPI-Verfahren wird ein Chip-Auswahl-Signal für jeden Baustein verwendet, so daß dieses Verfahren nachteilig dahingehend ist, daß je nach Ausbaustufe sehr viele Chip-Auswahl-Signale notwendig sind. Bei einem sogenannten EIB-System muß während der Konfiguration der Komponenten ein Taster an den Komponenten betätigt werden. Ferner ist es bekannt, eine Buskonfiguration durch Einstellen von DIP-Schaltern an den Modulen zu realisieren.

Die oben genannten Verfahren sind einerseits fehlerträchtig und stellen zum anderen jeweils einen zusätzlichen Arbeitsschritt dar, der Zeit und Kosten verursacht. Weiterhin ist bei der Herstellung der Komponenten durch die benötigten Einstellelemente ein erhöhter Bauteil- und damit Kostenaufwand erforderlich.

Die Aufgabe der vorliegenden Erfindung besteht darin, ein Verfahren zu schaffen, das eine Selbstkonfiguration von modularen elektronischen Systemen ermöglicht und somit die Vermeidung von Fehlern und Kosten unterstützt.

Diese Aufgabe wird durch ein Verfahren nach Anspruch 1 gelöst.

Eine weitere Aufgabe der vorliegenden Erfindung besteht darin, ein Modul für ein modulares elektronisches System zu schaffen, das eine Selbstkonfiguration des elektronischen Systems ermöglicht. Diese Aufgabe wird durch ein Modul nach Anspruch 10 gelöst.

Die vorliegende Erfindung schafft ein Verfahren zur Konfiguration eines modularen elektronischen Systems, das eine Mehrzahl von Modulen aufweist, wobei jedes Modul eine Anzahl von Modulschnittstellen aufweist, die der Anzahl von möglichen Nachbarn des Moduls entspricht, wobei eines der Module ein Mastermodul ist, in dem eine Konfigurationsdatei ablegbar ist. Das Verfahren beginnt damit, daß das Mastermodul, das die Steuerung innehat, ein Testsignal zu einem potentiellen Nachbarmodul ausgibt, und, wenn das Nachbarmodul tatsächlich vorliegt, eine Antwort von dem Nachbarmodul empfängt und das Nachbarmodul in die Konfigurationsdatei einträgt, wobei darüberhinaus das Nachbarmodul selbst ebenfalls als identifiziert gekennzeichnet wird. Dies wird für alle potentiellen Nachbarmodule wiederholt, so daß nachfolgend alle vorliegenden, zu dem Mastermodul benachbarten Module in die Konfigurationsdatei eingetragen sind. Im Anschluß wird die Steuerung auf ein dabei identifiziertes Nachbarmodul des Mastermoduls übertragen, woraufhin das oben bezugnehmend auf das Mastermodul beschriebene Verfahren wiederholt wird, um sämtliche zu dem Modul, das nun die Steuerung innehat, benachbarte Module, die noch nicht gekennzeichnet wurden, in die Konfigurationsdatei einzutragen.

Das oben beschriebene Verfahren wird in analoger Weise fortgesetzt, bis alle Module in die Konfigurationsdatei eingetragen sind, indem die Steuerung stets jeweils zu benachbarten Modulen weitergegeben wird, bis schließlich festgestellt wird, daß das momentan die Steuerung innehabende Modul keine tatsächlich vorliegenden, nicht gekennzeichneten Nachbarmodule aufweist. Ist dies der Fall, wird die Steuerung von dem die Steuerung momentan innehabenden Modul auf das Modul rückübertragen, von dem dieses die Steuerung erstmals erhalten hat. Falls nun ein Nachbarmodul des Moduls, auf das die Steuerung rückübertragen wurde, existiert, das die Steuerung noch nicht innehatte, wird die Steuerung auf dieses Nachbarmodul übertragen. Dann werden analog zu dem oben bezugnehmend auf das Nachbarmodul beschriebenen Verfahren alle vorhandenen und noch nicht gekennzeichneten Nachbarmodule des nun die Steuerung innehabenden Moduls bestimmt. Falls ein solches Nachbarmodul, das die Steuerung noch nicht innehatte, nicht existiert, wird der Schritt der Rückübertragung der Steuerung wiederholt, wenn das nun die Steuerung innehabende Modul nicht das Mastermodul ist, wohingegen das Verfahren beendet wird, wenn das die Steuerung innehabende Modul das Mastermodul ist.

Ein Modul, mit dem das oben beschriebene Verfahren durchgeführt werden kann, umfaßt eine Steuereinrichtung und eine Modulschnittstelle für jedes potentielle Nachbarmodul des Moduls. Jede Modulschnittstelle weist einen Datenausgang auf, der über eine gemeinsame Datenleitung mit den Datenausgängen der anderen Modulschnittstellen und der Steuereinrichtung verbunden ist. Ferner besitzt jede Modulschnittstelle einen separaten Testausgang, der über eine zugeordnete Testleitung, die nicht mit den Testausgängen der anderen Module verbunden ist, mit der Steuereinrichtung verbunden ist. Ein elektronisches System kann dann durch eine Mehrzahl von Modulen mit einem derartigen Aufbau gebildet sein, wobei ein Modul als Mastermodul definiert wird.

Über den Testausgang wird dann jeweils das Testsignal zu einem potentiellen Nachbarmodul ausgegeben, wobei es möglich ist, zu jedem potentiellen Nachbarmodul ein Testsignal auf einer separaten Leitung auszugeben, da die Anzahl der Schnittstellen des Moduls der Anzahl der möglichen Nachbarmodule entspricht. Typinformationen und/oder Positionsinformationen, die zur Identifizierung der Module in der Konfigurationsdatei verwendet werden, werden über die Datenausgänge zwischen der Mehrzahl von Modulen übertragen. Die vorliegende Erfindung schafft somit ein Verfahren zur Konfiguration von modularen elektronischen Systemen und ein Modul, das die Durchführung eines solchen Verfahrens ermöglicht, die mit wenig technischem Aufwand eine Selbstkonfiguration bei mehrdimensionalen modularen elektronischen Systemen ermöglichen. Mögliche Anwendungsfelder für die vorliegende Erfindung sind beispielsweise intelligente Sensor-Arrays, intelligente Display-Arrays, Systeme der Kommunikationstechnik oder konfigurierbare Bedienpulte.

Weiterbildungen der vorliegenden Erfindung sind in den abhängigen Ansprüchen dargelegt.

Bevorzugte Ausführungsbeispiele der vorliegenden Erfindung werden nachfolgend bezugnehmend auf die beiliegenden Zeichnungen näher erläutert. Es zeigen:
- Fig. 1: eine schematische Darstellung eines erfindungsgemäßen Moduls für ein modulares elektronisches System;
- Fig. 2 bis 5: schematische Darstellungen zur Erläuterung des erfindungsgemäßen Verfahrens; und
- Fig. 6 und 7: schematische Darstellungen zur Erläuterung einer Abwandlung des erfindungsgemäßen Verfahrens.

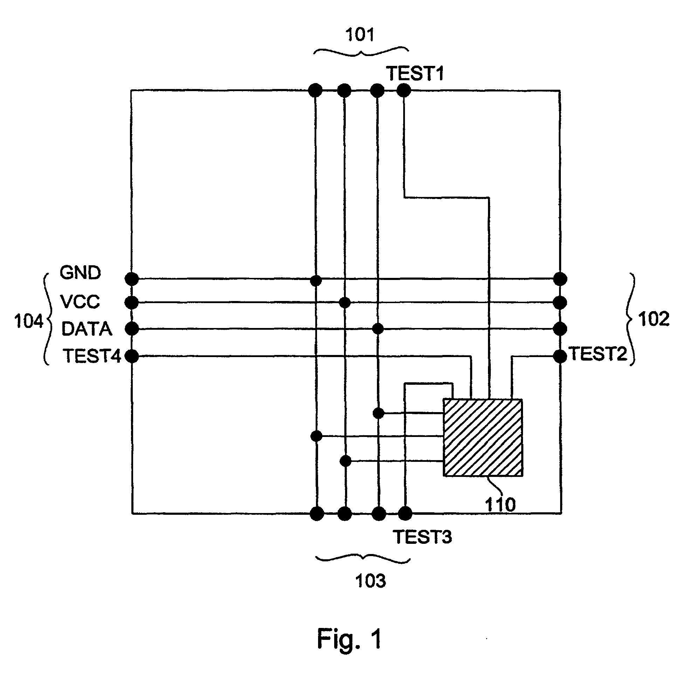

Nachfolgend wird zunächst bezugnehmend auf Fig. 1 der Aufbau eines erfindungsgemäßen Moduls für ein modulares elektronisches System erläutert, wobei ein solches Modul vorteilhaft die Durchführung des erfindungsgemäßen Verfahrens zur Konfiguration bzw. Selbstkonfiguration eines modularen elektronischen Systems ermöglicht.

Alle Komponenten bzw. Module eines modularen elektronischen Systems verfügen über eine einheitliche Anordnung von Schnittstellen, mit denen eine Kommunikation untereinander möglich ist. Eine solche Komponente oder ein solches Modul ist in Fig. 1 dargestellt. Das in Fig. 1 dargestellte Modul weist vier Seiten auf und ist für eine zweidimensionale Anordnung geeignet. Somit kann das in Fig. 1 dargestellte Modul vier potentielle Nachbarmodule aufweisen, eines an jeder Seite desselben, so daß vier Schnittstellen 101, 102, 103 und 104 vorgesehen sind. Obwohl in der nachfolgenden Beschreibung 12 von einem rechteckigen bzw. quadratischen Modul mit vier Schnittstellen ausgegangen wird, sollte es klar sein, daß abhängig von den mechanischen Randbedingungen auch unterschiedlich ausgestaltete Module denkbar sind, beispielsweise dreieckige oder würfelförmige Module, wobei dann natürlich die Anzahl der Modulschnittstellen variiert. Die nachfolgenden Ausführungen beziehen sich überdies auf eine zweidimensionale Anordnung, wobei jedoch eine Selbstkonfiguration dreidimensionaler Strukturen ebenfalls nach dem erfindungsgemäßen Verfahren möglich ist.

wie in Fig. 1 gezeigt ist, besitzt das Modul für das modulare elektronische System eine Steuereinrichtung 110, wobei der Ausdruck "Steuereinrichtung", wie er hierin verwendet ist, jegliche Art von Verarbeitungseinrichtung sowie dazugehörigen Sensoren und dergleichen, umfassen soll. Die Steuereinrichtung 110 umfaßt vorzugsweise eine Mikrosteuerung oder dergleichen. Jede der Modulschnittstellen 101 bis 104 weist zwei Anschlüsse GND und VCC auf, die zur Betriebsspannungsversorgung dienen, wobei diese Betriebsspannungsversorgungsanschlüsse vorzugsweise über gemeinsame Verbindungsleitungen mit der Steuereinrichtung 110 verbunden sind. Ferner weist jede Modulschnittstelle einen Datenausgang DATA auf, wobei die Datenausgänge über Datenleitungen miteinander und mit der Steuereinrichtung 110 verbunden sind. Über diese Datenausgänge DATA, bzw. die Datensammelleitung, die mit denselben verbunden ist, welche vorzugsweise als Busleitung ausgelegt ist, wird die Kommunikation zwischen allen Modulen des Gesamtsystems abgewickelt. Darüberhinaus besitzt jede Modulschnittstelle einen individuellen Testausgang TEST1, TEST2, TEST3 bzw. TEST4. Jeder dieser Testausgänge ist einzeln mit der Steuereinrichtung 110 verbunden. Auf den individuellen Testausgängen wird ein individuelles Testsignal empfangen, das je nach Systemzustand Input- oder auch Output-Funktion besitzt. Diesbezüglich sei angemerkt, daß mit dem Ausdruck "Ausgang" in der vorliegenden Anmeldung jeweils Schnittstellen gemeint sind, die sowohl das Senden von Daten als auch das Empfangen von Daten erlauben. Bei bevorzugten Ausführungsbeispielen der vorliegenden Erfindung liegen sowohl an den Datenausgängen als auch den Testausgängen Open-Kollektor-Signale mit einem aktiven Low-Pegel an, d.h., daß im inaktiven Zustand diese Signale über Pullup-Widerstände auf einen hohen Pegel gelegt sind.

Das bezugnehmend auf Fig. 1 beschriebene Modul eignet sich zum Aufbau eines modularen elektronischen Systems, indem die jeweiligen Schnittstellen einer Mehrzahl solcher Module miteinander verbunden werden, wobei das in Fig. 1 gezeigte Modul vier potentielle Nachbarmodule besitzen kann, die über die Modulschnittstellen 101 bis 104 mit dem dargestellten Modul verbunden werden können. Ein Modul, das sogenannte Mastermodul, das in jedem System genau einmal vorhanden sein muß, nimmt eine Sonderrolle ein. Dasselbe startet den erfindungsgemäßen Konfigurationsprozeß. Alle andere Module sind zunächst inaktiv und reagieren nur auf Stimuli an ihren Modulschnittstellen. Die Voraussetzung, daß ein Mastermodul existieren muß, stellt im allgemeinen keine Einschränkung dar, da ein modulares System meistens über zentrale Funktionen und eine gemeinsame Schnittstelle zur Außenwelt verfügt, die man sinnvollerweise im Mastermodul ansiedeln kann. Das Mastermodul muß ferner in der Lage sein, eine Konfigurationsdatei, als eine Datenbasis, in der die Systemkonfiguration aufgezeichnet ist, anzulegen.

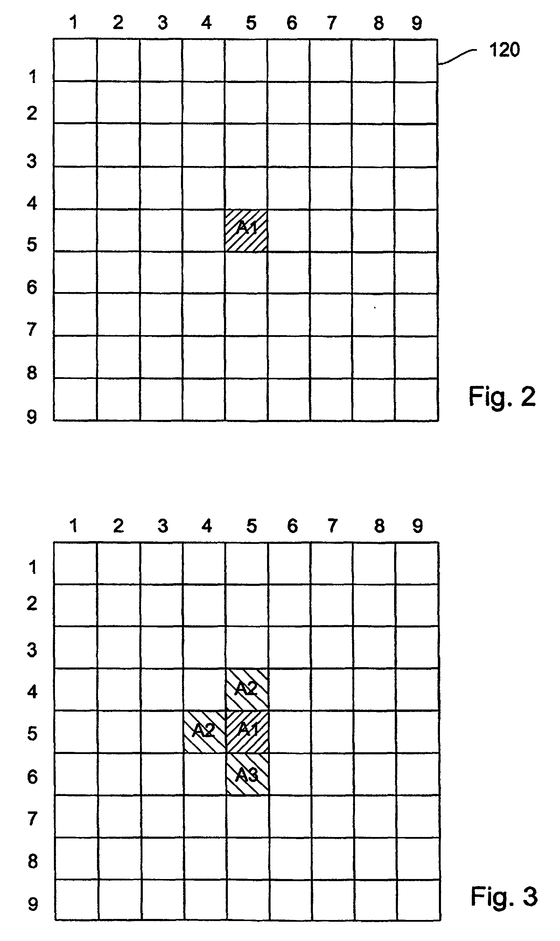

Nachfolgend wird ein Ausführungsbeispiel des erfindungsgemäßen Verfahrens für Module mit vier Modulschnittstellen, wobei ein solches Modul oben bezugnehmend auf Fig. 1 beschrieben wurde, bezugnehmend auf die Fig. 2 bis 5 erläutert. Wie oben erläutert wurde, übernimmt das Mastermodul die Leitung des Konfigurationsprozesses und legt bei dem nachfolgend beschriebenen Ausführungsbeispiel als Datenbasis, die als Konfigurationsdatei dient, zunächst eine matrixförmige Speicheranordnung, die in Fig. 2 allgemein mit 120 bezeichnet ist, an. In dieser matrixförmigen Speicheranordnung 120 wird die Konfigurationsmatrix gebildet, wobei die Konfigurationsmatrix zu Beginn des erfindungsgemäßen Konfigurationsverfahrens leer ist, bzw. gelöscht wird. Die Größe der Konfigurationsmatrix hängt von der maximalen Größe des zu konfigurierenden Systems ab. Wird davon ausgegangen, daß das Gesamtsystem eine maximale Größe von N x M Elementen aufweisen kann, wird bei dem dargestellten Ausführungsbeispiel die Konfigurationsmatrix mit einer Größe von (2N-1) x (2M-1) Elementen angelegt. Die in den Figuren dargestellte Konfigurationsmatrix 120 ist somit eine Konfigurationsmatrix für ein Gesamtsystem mit einer maximalen Größe von 5 x 5 Elementen, also N = M = 5, wobei die Matrix 9 x 9 Elemente aufweist.

Das Mastermodul trägt sich nun selbst an der Mittelposition, also der Position (5,5) in Fig. 2, der Matrix mit seiner Kennung, bei dem dargestellten Beispiel der Kennung "A1", ein. Diese Kennung kann spezifische Typinformationen bezüglich des Mastermoduls darstellen. Die Konfigurationsmatrix nach dem Eintrag der Kennung des Mastermoduls ist in Fig. 2 gezeigt.

Das Mastermodul aktiviert nun als erstes sein Testsignal auf dem Testausgang TEST1 an seinen potentiellen Nachbarn am oberen Rand. Über den Datenausgang DATA gibt es die Position des potentiellen Nachbarn aus, d.h. die Zeile und die Spalte desselben innerhalb der Matrix. Bei dem dargestellten Ausführungsbeispiel lauten diese Positionsinformationen (4,5). Existiert nun ein Nachbar am oberen Rand in der Position (4,5), so gibt dieser als Antwort über die DATA-Sammelleitung seine Position und seine individuelle Typkennung, bei dem dargestellten Ausführungsbeispiel "A2", zurück, die das Mastermodul empfängt und in die Konfigurationsmatrix einträgt. Jedes auf diese Weise erkannte und in die Konfigurationsmatrix eingetragene Modul merkt sich die ihm übertragene Position, so daß es später damit adressiert werden kann.

Auf die oben beschriebene Weise spricht das Mastermodul, A1, seine vier potentiellen Nachbarn an den Positionen (4,5) (5,6) (6,5) und (5,4) an. Ist eine der Nachbarpositionen nicht besetzt, d.h. liegt dort tatsächlich kein Modul vor, wird das Mastermodul von demselben als Antwort auf das Testsignal nicht eine Position und eine individuelle Typkennung erhalten. Vielmehr wird nach einem vorbestimmten Zeitablauf das vergebliche Warten auf die Antwort des nicht vorhandenen Moduls beendet. Bei dem beschriebenen Ausführungsbeispiel sind die Positionen (4,5) und (5,4) mit Modulen vom Typ "A2" besetzt, während die Position (6,5) mit einem Modul vom Typ "A3" besetzt ist, wie in Fig. 3 zu sehen ist. Ferner ist aus Fig. 3 entnehmbar, daß die Position (5,6) unbesetzt ist.

Nach der oben beschriebenen Vorgehensweise kennt das Mastermodul nun alle seine unmittelbaren Nachbarn, die es über seine vier TEST-Ausgänge ansprechen kann. Alle anderen potentiell vorhandenen Module des Gesamtsystems kann das Mastermodul nicht über seine TEST-Ausgänge mit seinen TEST-Signalen erreichen. Erfindungsgemäß wird daher die Regie des Konfigurationsvorgangs nun an die bereits gefundenen und identifizierten Nachbarn des Mastermoduls abgegeben. Bei dem dargestellten Ausführungsbeispiel gibt das Mastermodul die Regie, d.h. die Steuerung, zunächst an seinen Nachbarn am oberen Rand, der sich an der Position (4,5) befindet, ab. Dieses Nachbarmodul steuert nun den Konfigurationsprozeß identisch wie zuvor das Mastermodul und spricht seine unmittelbaren Nachbarn über seine TEST-Ausgänge an, um festzustellen, welche Nachbarpositionen tatsächlich mit Nachbarmodulen besetzt sind. Dabei ist anzumerken, daß Module, die bereits vorher angesprochen und identifiziert worden sind, entsprechend gekennzeichnet wurden und somit nicht mehr auf das ankommende TEST-Signal reagieren. Dies gilt beispielsweise für das Mastermodul selbst.

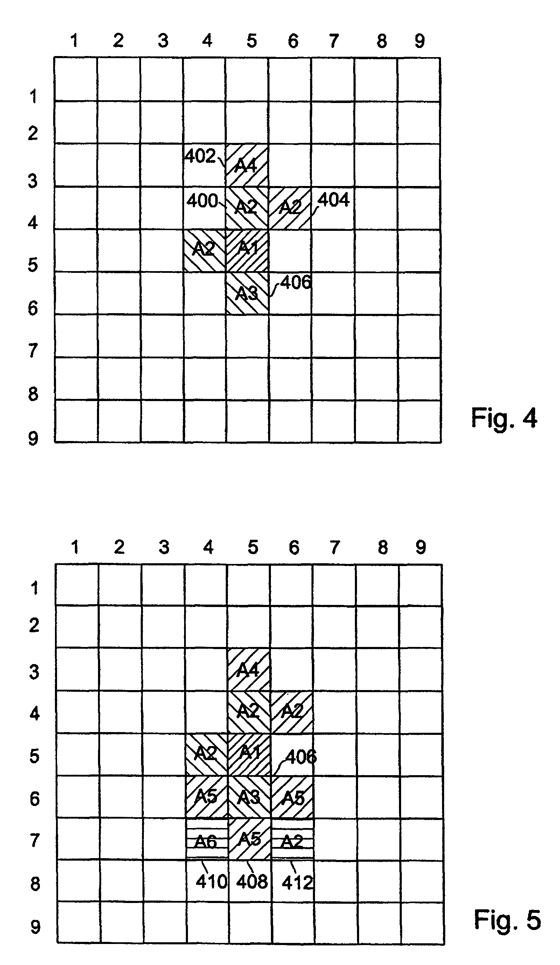

Während das Modul an der Position (4,5) das Verfahren zum Bestimmen der tatsächlich anwesenden Nachbarmodule durchführt, hört das Mastermodul die Informationen auf der DATA-Leitung ab und erfährt so die Positionen und die jeweiligen individuellen Kennungen der gefundenen Module, wobei das Mastermodul jedes Modul entsprechend in die Konfigurationsmatrix einträgt. Das Modul 400 an der Position (4,5) erfaßt auf diese Weise seine Nachbarn, wobei an der Position (3,5) ein Modul 402 vom Typ "A4" erfaßt wird, während an der Position (4,6) wiederum ein Modul 404 vom Typ "A2" erfaßt wird. Wie ferner in Fig. 4 zu erkennen ist, liegt an der Position (4,4) tatsächlich kein Modul vor. Der Zustand der Konfigurationsmatrix, nachdem das Modul 400 an der Position (4,5) seine Nachbarmodule abgefragt hat, ist in Fig. 4 gezeigt.

Nachdem das Modul 400 seine Nachbarn erfaßt hat, gibt es die Kontrolle wiederum an ein erfaßtes Nachbarmodul ab, bei dem gezeigten Ausführungsbeispiel das Modul 402 an der Position (3,5). Es sei nun angenommen, daß das Modul 402 außer dem Modul 400 kein weiteres benachbartes Modul besitzt, sich also am Rand des Gesamtsystems befindet. Eine Abfrage durch das Modul 402 hat zur Folge, daß kein Nachbarmodul antwortet, da das Modul 400 als bereits in die Konfigurationsdatei eingetragen gekennzeichnet ist. Somit gibt das Modul 402 die Kontrolle des Konfigurationsvorgangs an das Nachbarmodul ab, von dem es die Kontrolle erhalten hat, bei dem beschriebenen Ausführungsbeispiel also das Modul 400. Dieses Modul gibt die Kontrolle dann an seinen nächsten Nachbarn weiter. Bei dem beschriebenen Ausführungsbeispiel haben das Modul 402 an der Position (3,5) und das Modul 404 an der Position (4,6) keine weiteren Nachbarn. Somit geben sowohl das Modul 402 als auch das Modul 404 die Kontrolle an das Modul 400 an der Position (4,5) zurück. Neben den Modulen 402 und 404 hat das Modul 400 keine weiteren Nachbarn, die es erkannt hat, so daß es die Kontrolle an das Mastermodul "A1" zurückgibt, von dem es ursprünglich, also erstmals, die Kontrolle erhalten hat.

Das Mastermodul gibt nun die Kontrolle an das nächste Modul ab, das es selbst gefunden hat. Bei dem dargestellten Ausführungsbeispiel ist dies das Modul 406, siehe Fig. 4, an der Position (6,5) mit der Kennung "A3". Das heißt, daß bei dem beschriebenen Ausführungsbeispiel das Mastermodul die Steuerung an jeweils gefundene Nachbarmodule in der Reihenfolge oben, unten, rechts, links weitergibt. Es ist jedoch klar, daß die Reihenfolge, in der die Steuerung auf gefundene Nachbarmodule weitergegeben wird, völlig willkürlich ist, so daß in gleicher Weise die Steuerung auch im Uhrzeigersinn bzw. gegen den Uhrzeigersinn an die Nachbarmodule weitergegeben werden könnte.

Das Modul 406 findet nun entsprechend dem oben beschriebenen Verfahren seine weiteren Nachbarn, bei denen es sich um drei Module mit der Kennung "A5" an den Positionen (6,4), (7,5) und (6,6) handelt. Das Modul 406 an der Position (6,5) gibt nun die Steuerung in der festgelegten Reihenfolge an seine Nachbarmodule, die die Steuerung noch nicht innehatten, weiter, so daß das Modul 406 bei dem dargestellten Ausführungsbeispiel die Steuerung an das Modul 408, siehe Fig. 5, an der Position (7,5) weitergibt, da das Modul mit der Kennung "A1" an der Position (5,5) das Mastermodul ist, das die Steuerung bereits innehatte. Nun durchsucht das Modul 408 an der Position (7,5) seine Nachbarmodule, und findet ein Modul 410 mit der Kennung "A6" an der Position (7,4) und ein Modul 412 mit der Kennung "A2" an der Position (7,6). Dieses Verfahren setzt sich nun fort, bis alle Module in dem Gesamtsystem erfaßt sind und das Mastermodul die Konfigurationsmatrix entsprechend aktualisiert hat. Im vorliegenden Fall sei davon ausgegangen, daß das Gesamtsystem lediglich die in Fig. 5 dargestellten elf Module besitzt. Nachdem das Modul 408 seine Nachbarmodule 410 und 412 erfaßt hat, gibt es somit die Steuerung nacheinander zu diesen Modulen ab. Da diese keine weiteren Nachbarmodule besitzen, geben sie die Steuerung an das Modul 408 zurück. Auch das Modul 408 besitzt keine weiteren Nachbarmodule, so daß es die Steuerung zu dem Modul, von dem es ursprünglich die Steuerung erhalten hat, also dem Modul 406, zurückgibt. Das Modul 406 gibt dann die Steuerung mangels weiterer Nachbarmodule, die die Steuerung noch nicht innehatten, zu dem Mastermodul mit der Kennung "A1" zurück. Im vorliegenden Fall sind somit alle Module erfaßt, so daß das Verfahren endet.

Das Mastermodul kennt nun alle besetzten Positionen sowie die Identitäten, d.h. die Typen, der vorhandenen Module. Die Module kennen aus dem oben beschriebenen Konfigurationsablauf ihre Positionen und sind damit über die DATA-Leitung mit Hilfe geeigneter serieller Informationseinheiten, sogenannten "Telegrammen", vom Mastermodul adressierbar.

Nach der Konfigurierung übernimmt das Mastermodul den Datenaustausch zwischen den Modulen, indem es gezielt eine Verbindung zu einem Modul oder zwischen Modulen aufbaut. Jeder Datenaustausch auf der DATA-Leitung wird dabei vom Mastermodul initiiert, so daß Kollisionen durch gleichzeitiges Senden mehrerer Module ausgeschlossen werden können. Wenn ein Modul einen Datenaustausch anfordern will, so kann es diesen durch Aktivierung seiner TEST-Signale anfordern, die dann von den angrenzenden Modulen weitergeleitet werden und so das Mastermodul erreichen.

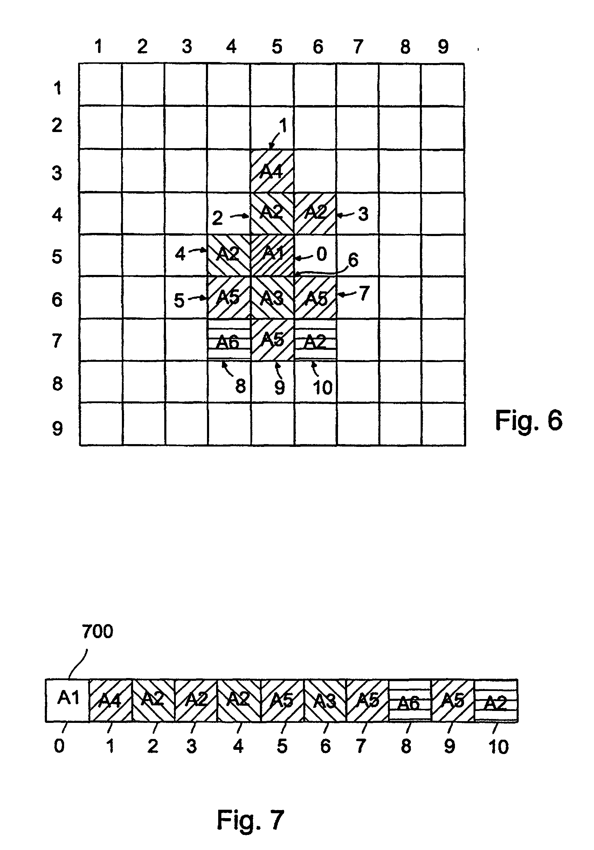

Bei dem oben genannten Ausführungsbeispiel werden die Typinformationen hinsichtlich der einzelnen Module in einer Konfigurationsmatrix abgelegt, wie es in Fig. 5 gezeigt ist. Das Mastermodul kann nun zum Abschluß des Konfigurationsvorgangs zeilenweise die Konfigurationsmatrix überprüfen und den Modulen in dieser Reihenfolge fortlaufende Nummern zuweisen, die im weiteren als Adresse zur Kommunikation dienen, wobei sich das Mastermodul selbst die Nummer 0 gibt. Diese Zuweisung von Nummern ist aus Fig. 6 zu erkennen. Auf diese Weise kann die Konfigurationsmatrix auf eine eindimensionale Speicherstruktur, siehe Fig. 7, mit deutlich geringerer Größe umgestellt werden. Ferner kann die Länge der Adresse auf diese Weise reduziert werden, was zu einer Beschleunigung des Datenverkehrs zwischen den Modulen führt.

Bei dem erfindungsgemäßen Aufbau eines Moduls, der in Fig. 1 gezeigt ist, ist es ferner möglich, daß das Mastermodul nach Abschluß des Konfigurationsvorgangs die Orientierung der übrigen Module zu sich selbst ermittelt. Dies erfolgt durch die gezielte Aktivierung von TEST-Ausgängen mit TEST-Signalen über Telegramme und eine nachfolgende Auswertung. Bei gleicher Orientierung aller Module müssen jeweils die TEST1- und TEST3-Ausgänge benachbarter Module miteinander verbunden sein, ebenso wie die TEST2- und TEST4-Ausgänge. Sofern mechanisch eine Verdrehung der Module möglich ist, kann bei einer Abweichung von der oben angegebenen Regel, die besagt, welche TEST-Ausgänge bei gleicher Orientierung miteinander verbunden sind, die Ausrichtung einzelner Module bestimmt werden. Bei dem oben beschriebenen Beispiel quadratischer Module kann es sich dabei um Verdrehungen von 90, 180 oder 270 Grad handeln. Diese Informationen bezüglich der Orientierung der Module kann beispielsweise genutzt werden, um eine einheitliche Zählweise von auf den Modulen plazierten Sensoren oder Bedienelementen sicherzustellen. Sollten etwa Sensoren jeweils von oben nach unten durchnumeriert sein, kann ein "auf dem Kopf" montiertes Modul erkannt und entsprechend berücksichtigt werden. Dies kann Anwendung beispielsweise bei einem intelligenten Füllstandsensor finden, der aus mehreren Sensorelementen besteht.

## Patentansprüche

1. Verfahren zur Konfiguration eines modularen elektronischen Systems, das eine Mehrzahl von Modulen aufweist, wobei jedes Modul eine Steuereinrichtung (110) und eine Mehrzahl von Modulschnittstellen (101 bis 104) aufweist, die der Anzahl von möglichen Nachbarn des Moduls entspricht, wobei eines der Module ein Mastermodul ist, in dem eine Konfigurationsdatei (120) ablegbar ist, wobei jede Modulschnittstelle (101 bis 104) einen Datenausgang (DATA), der über eine gemeinsame Datenleitung mit den Datenausgängen der anderen Modulschnittstellen und der Steuereinrichtung (110) verbunden ist, und einen separaten Testausgang (TEST1 bis TEST4), der mit der Steuereinrichtung (110) und nicht mit den Testausgängen der anderen Modulschnittstellen verbunden ist, aufweist, wobei die Mehrzahl von Modulen über einen gemeinsamen Datenbus verbunden ist, mit folgenden Schritten:
beginnend mit dem eine Steuerung innehabenden Mastermodul:
a) Ausgeben eines Testsignals zu einem potentiellen Nachbarmodul über den Testausgang einer Modulschnittstelle, und, wenn das potentielle Nachbarmodul tatsächlich vorliegt, a1) Empfangen einer Antwort von dem Nachbarmodul über den Datenbus, a2) Eintragen der Position des Nachbarmoduls in die Konfigurationsdatei (120), a3) Kennzeichnen des Nachbarmoduls als identifiziert, und a4) Speichern der Position in dem Nachbarmodul;
b) Wiederholen des Schritts a) für alle potentiellen Nachbarmodule des die Steuerung innehabenden Moduls;
c) Übertragen der Steuerung auf ein im Schritt a) identifiziertes Nachbarmodul; und
d) Wiederholen der Schritte a) und b) für das die Steuerung innehabende Modul, wobei die Schritte a1), a2), a3) nur für ein solches tatsächlich vorliegendes Nachbarmodul durchgeführt werden, das nicht gekennzeichnet ist.

2. Verfahren nach Anspruch 1, das ferner den Schritt e) des Wiederholens der Schritte c) und d) aufweist, bis festgestellt wird, daß das momentan die Steuerung innehabende Modul keine tatsächlich vorliegenden, nicht gekennzeichneten Nachbarmodule aufweist.

3. Verfahren nach Anspruch 2, das ferner folgende Schritte aufweist:
f) Rückübertragen der Steuerung von dem die Steuerung innehabenden Modul auf das Modul, von dem dieses die Steuerung erstmals erhalten hat; und
falls ein Nachbarmodul des die Steuerung innehabenden Moduls existiert, das die Steuerung noch nicht innehatte,
g) Übertragen der Steuerung auf dieses Nachbarmodul und Durchführen der Schritte a) und b);
andernfalls,
h) Wiederholen des Schritts f), wenn das die Steuerung innehabende Modul nicht das Mastermodul ist, und Beenden des Verfahrens, wenn das die Steuerung innehabende Modul das Mastermodul ist.

4. Verfahren nach einem der Ansprüche 1 bis 3, bei dem im Schritt a) Typinformationen von dem Nachbarmodul empfangen werden, die im Schritt a2) in der Konfigurationsdatei (120) abgelegt werden.

5. Verfahren nach einem der Ansprüche 1 bis 4, bei dem Typinformationen und Positionsinformationen über den gemeinsamen Datenbus übertragen werden.

6. Verfahren nach einem der Ansprüche 1 bis 5, bei dem das Mastermodul die Konfigurationsdatei in der Form einer zweidimensionalen Konfigurationsmatrix (120) speichert, die eine Größe von (2N-1) x (2M-1) Elementen aufweist, wenn das elektronische System eine maximale Größe von N x M Elementen aufweist, wobei Typinformationen bezüglich des Mastermoduls in der Mitte der Konfigurationsmatrix abgelegt werden, während Typinformationen bezüglich anderer Module entsprechend ihren Positionsinformationen in der Konfigurationsmatrix abgelegt werden.

7. Verfahren nach einem der Ansprüche 4 bis 6, bei dem die Typinformationen zusammen mit den zugeordneten Positionsinformationen in der Konfigurationsdatei abgelegt werden.

8. Verfahren nach Anspruch 6, bei dem nach Fertigstellung der Konfigurationsmatrix (120) dieselbe in eine eindimensionale Speicherstruktur (700) umgewandelt wird, wobei jedem identifizierten Modul als Adresse eine Nummer zugewiesen wird.

9. Verfahren nach Anspruch 5, das ferner den Schritt des Ermitteins der Ausrichtung der identifizierten Module aufweist, indem geprüft wird, mit welchen Testleitungen jeweilige Module miteinander verbunden sind.

10. Modul für ein modulares elektronisches System zur Verwendung bei einem Verfahren gemäß einem der Ansprüche 1 bis 9, mit folgenden Merkmalen:
einer Steuereinrichtung (110); und
einer Modulschnittstelle (101 bis 104) für jedes potentielle Nachbarmodul des Moduls,
wobei jede Modulschnittstelle (101 bis 104) folgende Merkmale aufweist:
einen Datenausgang (DATA), der über eine gemeinsame Datenleitung mit den Datenausgängen der anderen Modulschnittstellen und der Steuereinrichtung (110) verbunden ist; und
einen separaten Testausgang (TEST1 bis TEST4), der über eine zugeordnete Testleitung, die nicht mit den Testausgängen der anderen Modulschnittstellen verbunden ist, mit der Steuereinrichtung (110) verbunden ist.

## Claims

1. Method for the configuration of a modular electronic system comprising a plurality of modules, wherein each module comprises a control means (110) and a plurality of module interfaces (101 to 104) corresponding to the number of possible neighbors of the module, wherein one of the modules is a master module in which a configuration file (120) may be stored, wherein each module interface (101 to 104) comprises a data output (DATA) connected to the data outputs of the other module interfaces and the control means (110) via a common data line, and a separate test output (TEST1 to TEST4) which is connected to the control means (110) and not to the test outputs of the other module interfaces, wherein the plurality of modules are connected via a common data bus, comprising:
starting with the master module holding control:
a) outputting a test signal to a potential neighbor module via the test output of a module interface, and when the potential neighbor module is indeed present, a1) receiving an answer from the neighbor module via the data bus, a2) inputting the position of the neighbor module into the configuration file (120), a3) designating the neighbor module as being identified and a4) storing the position within the neighbor module;
b) repeating the steps a) for all potential neighbor modules of the module holding the control;
c) transferring the control to a neighbor module identified in step a; and
d) repeating the steps a) and b) for the module holding the control, wherein the steps a1), a2), a3) are only performed for such an actually present neighbor module which is not designated.

2. Method according to claim 1, further comprising the step e) of repeating the steps c) and d), until it is determined that the module currently holding the control comprises no actually present non-designated neighbor modules.

3. Method according to claim 2, further comprising the following steps:
f) passing back the control from the module holding the control to the module from which it originally received the control; and
if a neighbor module of the module holding the control exists which has not yet held the control,
g) passing the control to this neighbor module
and performing the steps a) and b);
otherwise,
h) repeating step f) if the module holding the control is not the master module, and terminating the method if the module holding the control is the master module.

4. Method according to one of claims 1 to 3, wherein in step a) type information of the neighbor module is received which is stored within the configuration file (120) in step a2).

5. Method according to one of claims 1 to 4, wherein the type information and position information is transferred by the common data bus.

6. Method according to one of claims 1 to 5, wherein the master module stores the configuration file in the form of a two-dimensional configuration matrix (120), which comprises a size of (2N-1) x (2N-1) elements, if the electronic system comprises a maximum size of N x M elements, wherein type information regarding the master module is filed in the center of the configuration matrix, while type information regarding other modules is filed within the configuration matrix corresponding to their position information.

7. Method according to one of claims 4 to 6, wherein the type information is filed within the configuration file together with the associated position information.

8. Method according to claim 6, wherein after completing the configuration matrix (120) the same is converted into a one-dimensional memory structure (700) wherein a number is associated with each identified module as an address.

9. Method according to claim 5, further comprising the step of determining the alignment of the identified modules by testing with which test lines respective modules are connected to each other.

10. Module for a modular electronic system for being used in a method according to one of claims 1 to 9, comprising:
a control means (110); and
a module interface (101 to 104) for each potential neighbor module of the module,
wherein each module interface (101 to 104) further comprises:
a data output (DATA) connected to the data outputs of the other module interfaces and the control means (110) via a common data line; and
a separate test output (TEST1 to TEST4) which is connected to the control means (110) via an associated test line which is not connected to the test outputs of the other module interfaces.

## Revendications

1. Procédé de configuration d'un système électronique modulaire présentant une pluralité de modules, chaque module présentant un dispositif de commande (110) et une pluralité d'interfaces de module (101 à 104) correspondant au nombre de voisins possibles du module, l'un des modules étant un module principal dans lequel peut être installé un fichier de données de configuration (120), chaque interface de module (101 à 104) présentant une sortie de données (DATA) reliée, par l'intermédiaire d'une ligne de données commune, aux sorties de données des autres interfaces de module et au dispositif de commande (110), et une sortie de test séparée (TEST1 à TEST4) qui est reliée au dispositif de commande (110) et pas aux sorties de test des autres interfaces de module, la pluralité de modules étant reliées par l'intermédiaire d'un collecteur de données commun, aux étapes suivantes consistant à :
partant par le module principal possédant une commande :
a) sortir un signal de test vers un module voisin potentiel, par l'intermédiaire de la sortie de test d'une interface de module, et, lorsque le module voisin potentiel est effectivement présent, a1) recevoir une réponse du module voisin, par l'intermédiaire du collecteur de données, a2) entre la position du module voisin dans le fichier de données de configuration (120), a3) repérer le module voisin comme étant identifié, et a4) mémoriser la position dans le module voisin ;
b) répéter l'étape a) pour tous les modules voisins potentiels du module possédant la commande ;
c) transmettre la commande à un module voisin identifié à l'étape a) ; et
d) répéter les étapes a) et b) pour le module possédant la commande, les étapes a1), a2), a3) n'étant réalisées que pour un module voisin effectivement présent qui n'est pas repéré.

2. Procédé selon la revendication 1, présentant, par ailleurs, l'étape e) consistant à répéter les étapes c) et d), jusqu'à ce qu'il soit constaté que le module possédant momentanément la commande ne présente pas de modules voisins effectivement présents et non repérés.

3. Procédé selon la revendication 2, présentant, par ailleurs, les étapes suivantes consistant à :
f) retourner la commande du module possédant la commande au module duquel ce dernier a reçu la commande pour la première fois ; et
s'il existe un module voisin du module possédant la commande qui ne possédait pas encore la commande,
g) transmettre la commande à ce module voisin et réaliser les étapes a) et b) ;
sinon,
h) répéter l'étape f) si le module possédant la commande n'est pas le module principal et terminer le procédé si le module possédant la commande est le module principal.

4. Procédé selon l'une des revendications 1 à 3, dans lequel, à l'étape a), des informations de type sont reçus du module voisin, lesquelles sont entrées, à l'étape a2), dans le fichier de données de configuration (120).

5. Procédé selon l'une des revendications 1 à 4, dans lequel les informations de type et les informations de position sont transmises par l'intermédiaire du collecteur de données commun.

6. Procédé selon l'une des revendications 1 à 5, dans lequel le module principal mémorise le ficher de données de configuration sous forme d'une matrice de configuration bidimensionnelle (120) présentant une grandeur de (2N-1) x (2M-1) lorsque le système électronique présente une grandeur maximale de N x M éléments, les informations de type relatives au module principal étant entrées au centre de la matrice de configuration, tandis que les informations de type relatives à d'autres modules étant entrées dans la matrice de configuration conformément à leurs informations de position.

7. Procédé selon l'une des revendications 4 à 6, dans lequel les informations de type sont entrées ensemble avec les informations de position associées dans le fichier de données de configuration.

8. Procédé selon la revendication 6, dans lequel, après achèvement de la matrice de configuration (120), celle-ci est convertie en une structure de mémoire unidimensionnelle (700), à chaque module identifié étant attribué, comme adresse, un numéro.

9. Procédé selon la revendication 5, présentant, par ailleurs l'étape consistant à déterminer l'alignement des modules identifiés en vérifiant les lignes de test par lesquelles les modules respectifs sont reliés entre eux.

10. Module pour un système électronique modulaire destiné à être utilisé avec un procédé selon l'un des revendications 1 à 9, aux caractéristiques suivantes :
un dispositif de commande (110) ; et
une interface de module (101 à 104) pour chaque module voisin potentiel du module,
chaque interface de module (101 à 104) présentant les caractéristiques suivantes :
une sortie de données (DATA) reliée, par l'intermédiaire d'une ligne de données commune, aux sorties de données des autres interfaces de module et au dispositif de commande (110) ; et
une sortie de test séparée (TEST1 à TEST4) reliée, par l'intermédiaire d'une ligne de test associée non reliée aux sorties de test des autres interfaces de module, au dispositif de commande (110).
